# EUROPEAN PATENT APPLICATION

(11) **EP 1 003 283 A2**
(43) Date of publication of application: **24.05.2000**
(21) Application number: 99122781.0
(22) Date of filing: 16.11.1999
(51) Int. Cl.: H03G 3/30

(54) **Audio signal processing device**

(30) Priority: 17.11.1998 JP 32652898
(71) Applicant: Pioneer Corporation, Meguro-ku, Tokyo (JP)
(72) Inventor: Kageyama, Toru, c/o Pioneer Corporation, Kawagoe-shi, Saitama 350-0822 (JP); Takami,Yusuke, c/o Pioneer Corporation, Kawagoe-shi, Saitama 350-0822 (JP); Sasaki, Masaru, c/o Pioneer Corporation, Kawagoe-shi, Saitama 350-0822 (JP); Inohana, Haruyuki, c/o Pioneer Corporation, Kawagoe-shi, Saitama 350-0822 (JP); Sawaki, Manabu, c/o Pioneer Corporation, Kawagoe-shi, Saitama 350-0822 (JP)
(74) Representative: Grünecker, Kinkeldey, Stockmair & Schwanhäusser Anwaltssozietät

(57) **Abstract**

An audio signal processing device includes an audio signal control line including controllers for controlling a present value of each of a frequency characteristic, loudness, sound volume, fader of an input audio signal to designated values to be outputted, a zero crossing detector for detecting a timing when an amplitude of the input audio signal crosses a zero level of the audio signal; and a switching controller for switching the present value into the designated value in response to a switching command signal at the timing detected by the zero crossing detector. In this configuration, the zero level crossing timing of the audio signal is detected, and a designated controller makes the control operation at the zero level crossing timing. The click from a speaker can be eliminated.

## Description

### BACKGROUND OF THE INVENTION

### 1. Field of the Invention

The present invention relates to an audio signal processing device for processing an audio signal.

### 2. Description of the Related Art

As represented by an audio signal processing device for a vehicle, the audio signal processing device is provided with controllers for controlling the present values of the frequency characteristic, loudness and sound volume and fader of an input audio signal, respectively, according to user's preference.

In recent years, these controllers are designed in electronic circuits, and controlled in such a manner that the present values are discontinuously switched into values designated by the user.

In this way, in the conventional audio signal processing device, the controller designated when the designated value is inputted by the user makes a control operation.

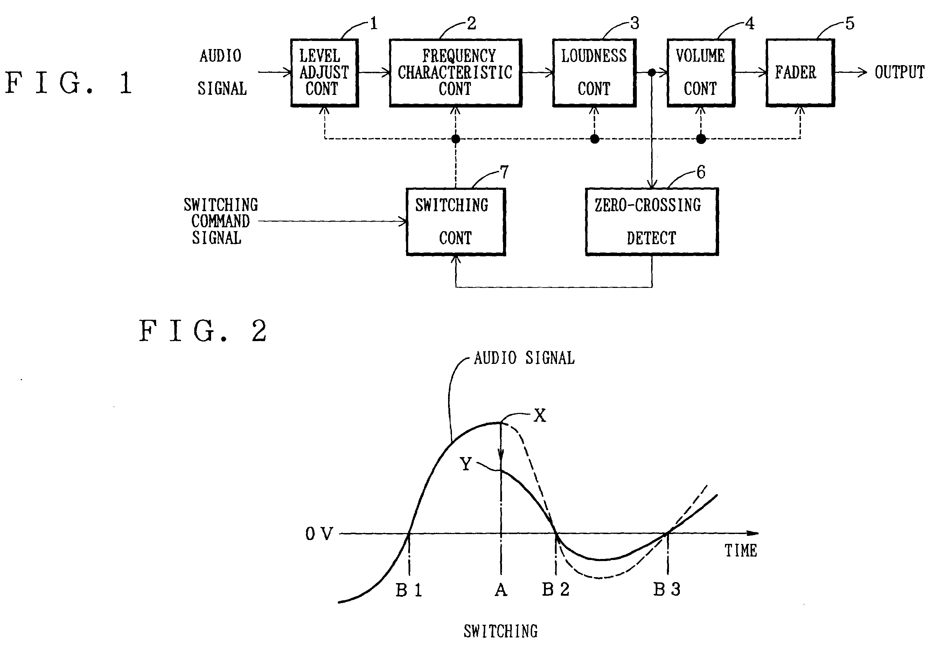

Therefore, as shown in Fig. 2, for example, when the designated value for adjusting the sound volume of an audio signal is input at timing A, the amplitude X of the audio signal varies abruptly at this timing A. Such an audio signal is produced from the audio signal processing device. The abrupt variation of the amplitude gave rise to clicks from a speaker.

### SUMMARY OF THE INVENTION

An object of the present invention is to provide an audio signal processing device which can prevent clicks from being generated from a speaker when a present value to be controlled is switched.

An audio signal processing device includes an audio signal control line including controllers for controlling a present value of each of a frequency characteristic, loudness, sound volume, fader of an input audio signal to designated values to be outputted, a zero crossing detector for detecting a timing when an amplitude of the input audio signal crosses a zero level of the audio signal; and a switching controller for switching the present value into the designated value in response to a switching command signal at the timing detected by the zero crossing detector. In this configuration, the zero level crossing timing of the audio signal is detected, and a designated controller makes the control operation at the zero level crossing timing. The click from a speaker can be eliminated.

Preferably, the audio signal control line comprises a sound volume controller for controlling the sound volume, and the zero crossing detector is connected in a rearward position of the controllers which generate transmission delay and connected to the input of the sound volume controller.
In this configuration, the zero crossing timing can be surely detected, and the click from the speaker can be eliminated.

Preferably, the system, zero crossing detector and switching controller are monolithically formed in an integrated circuit. In this configuration, the device configuration can be simplified.

The above and other objects and features of the present invention will be more apparent from the following description taken in conjunction with the accompanying drawing.

### BRIEF DESCRIPTION OF THE DRAWINGS

Fig. 1 is a block diagram of an embodiment of the audio signal processing device according to the present invention; and
Fig. 2 is a graph for explaining the problem of a prior art.

### DESCIPTION OF THE PREFERRED EMBODIMENT

Referring to Fig. 1, an explanation will be given of an audio signal processing device according to the present invention. Fig. 1 is a block diagram of the embodiment.

In Fig. 1, reference numeral 1 denotes a level control amplifier for adjusting the input level of an input audio signal which depends on an input source; 2 a frequency characteristic controller for the frequency characteristic of the treble and bass of the input audio signal; 3 denotes a loudness controller; 4 a sound volume controller; 5 a fader; 5 a zero-crossing detector for detecting the timing where the amplitude of an audio signal crosses the zero level; 7 a changing controller.

The zero-crossing detector 6 detects the timings of B1, B2 and B3, ... where the audio signal crosses 0 V.

A control (change instruction) signal, which is input by a user through an input means such as a dial, key, etc. (not shown), is supplied to the changing controller 7.

The switching instructing includes the number of a controller performing the switching control and a designated value. The input switching instructing signal is recorded on a memory (not shown).

When the control signal is recorded on the memory not shown, the changing controller 7 is on standby until the zero crossing timing is detected by the zero crossing detector 6. When the zero crossing timing is detected, the changing controller 7 issues an instruction for the controller corresponding to the recorded controller number to switch the present value into the recorded designated value.

The pertinent controller immediately changes the present value to be controlled. For example, when an instruction to change the attenuation degree into 4 dB is issued to the volume controller 4, the volume controller 4 controls the attenuator (not shown) so as to change the attenuation degree into 4 dB.

Both the frequency characteristic controller 2 and loudness controller 3 are constructed by circuits which change frequency characteristic. These controllers generate transmission delay. Therefore, in order to operate the controllers at the timing where the amplitude of the output audio signal crosses the zero level thereof so that a click from the speaker is not generated, the zero crossing detector 6 is arranged be in a rearward position of the frequency characteristic controller 2 and loudness controller 3.

The zero crossing detector 6 is connected to the input of the sound volume controller 4. In this case, even when the sound volume controller 4 is operated, the audio signal at a prescribed level is supplied to the input of the zero crossing detector 6 so that the zero crossing timing can be surely detected.

The frequency characteristic controller 2 and loudness controller 3 are adapted to make the frequency control in a switch capacitor filter configuration. The other controllers are also adapted to make the control in electronics. All the controllers are monolithically designed in an integrated circuit so that the device configuration can be simplified.

## Claims

1. An audio signal processing device comprising:
an audio signal control line including controllers for controlling a present value of each of a frequency characteristic, loudness, sound volume, fader of an input audio signal to designated values to be outputted;
a zero crossing detector for detecting a timing when an amplitude of the input audio signal crosses a zero level of the audio signal; and
a switching controller for switching said present value into the designated value in response to a switching command signal at said timing detected by said zero crossing detector.

2. An audio signal processing device according to claim 1, wherein said audio signal processing line comprises a sound volume controller for controlling said sound volume, and said zero crossing detector is connected in a rearward position of the controllers which generate transmission delay and connected to the input of said sound volume controller.

3. An audio signal processing device according to claim 1, wherein said audio signal processing line, zero crossing detector and switching controller are monolithically formed in an integrated circuit.

4. An audio signal processing device according to claim 1, wherein said audio signal processing line, zero crossing detector and switching controller are monolithically formed in an integrated circuit.
